(19) Europäisches Patentamt
European Patent Office
Office européen des brevets

(11) **EP 1 596 209 B1**

(12) **FASCICULE DE BREVET EUROPEEN**

(45) Date de publication et mention
de la délivrance du brevet:
**08.04.2015 Bulletin 2015/15**

(51) Int Cl.:
***G01R 31/00*** *(2006.01)*

(21) Numéro de dépôt: **05290925.6**

(22) Date de dépôt: **27.04.2005**

(54) **Dispositif de mesure d'un champ électromagnétique, système de commande utilisant ce dispositif et circuit électronique concu pour ce dispositif**

Vorrichtung zur Messung eines elektromagnetischen Feldes, zugehöriges Steuersystem und zugehörige& xA;elektronische Schaltung

Electromagnetic field measuring device, its control system, and its electronic circuit

(84) Etats contractants désignés:
**AT BE BG CH CY CZ DE DK EE ES FI FR GB GR HU IE IS IT LI LT LU MC NL PL PT RO SE SI SK TR**

(30) Priorité: **14.05.2004 FR 0405299**

(43) Date de publication de la demande:
**16.11.2005 Bulletin 2005/46**

(73) Titulaire: **ALSTOM Transport Technologies**
**92300 Levallois-Perret (FR)**

(72) Inventeurs:
• **Lourdel, Guillaume**
**65000 Tarbes (FR)**
• **Dutarde, Emmanuel**
**64800 Mirepeix (FR)**
• **Dienot, Jean-Marc**
**65800 Orleix (FR)**

(74) Mandataire: **Habasque, Etienne J. Jean-François et al**
**Cabinet Lavoix**
**2, place d'Estienne d'Orves**
**75441 Paris Cedex 09 (FR)**

(56) Documents cités:
**US-A- 4 904 925**

## Description

La présente invention concerne un dispositif de mesure d'un champ électromagnétique, un système de commande utilisant ce dispositif et un circuit électronique conçu pour ce dispositif.

Des dispositifs connus de mesure d'un champ électromagnétique rayonné par un composant électrique d'un circuit électronique, comporte :

- un appareil de mesure d'une énergie électrique indépendant du circuit électronique,
- au moins un transducteur raccordé à l'appareil de mesure, ce transducteur étant apte à convertir le champ électromagnétique rayonné par le composant électrique en une énergie électrique mesurée par l'appareil de mesure.

Dans les dispositifs connus, le transducteur est indépendant du circuit électronique et doit être positionné manuellement à proximité de l'endroit du circuit électronique dont on souhaite mesurer le rayonnement électromagnétique. Toutefois, la résolution spatiale des mesures réalisées à l'aide des dispositifs connus reste imparfaite notamment à cause des imprécisions de positionnement du transducteur par rapport au circuit électronique.

Le document US 4 904 925 A décrit un appareil permettant de retrouver une variable alternative dans un semiconducteur asservi.

L'invention vise à remédier à cet inconvénient en proposant un dispositif permettant de mesurer avec une résolution spatiale accrue le champ électromagnétique rayonné par un circuit électronique.

L'invention a donc pour objet un dispositif de mesure d'un champ électromagnétique tel que décrit ci-dessus dans lequel le transducteur est gravé sur le substrat du circuit électronique.

Puisque le transducteur est gravé sur le substrat du circuit électronique, celui-ci est positionné avec précision à l'intérieur même du circuit électronique. Les problèmes d'imprécision dus au positionnement imparfait du transducteur par rapport au circuit électronique sont donc résolus.

Les modes de réalisation de ce dispositif de mesure peuvent comporter une ou plusieurs des caractéristiques suivantes :

- le ou chaque transducteur comporte une bobine, et l'appareil de mesure est apte à mesurer l'intensité du courant dans cette bobine ;
- la bobine est formée d'une piste électrique en forme de boucle gravée sur le substrat et dont les deux extrémités forment des plots de raccordement de la bobine à l'appareil de mesure ;
- la bobine ne comporte qu'une seule spire ;
- pour un circuit électronique dans lequel le composant électrique dont on doit mesurer le champ électromagnétique rayonné est une piste électrique raccordant en parallèle au moins une première et une seconde puces de commutation de courant, le ou l'un des transducteurs est gravé sur le substrat à un emplacement choisi pour être plus exposé au champ électromagnétique créé par le courant commuté par la première puce que celui créé par le courant commuté par la seconde puce.

L'invention a également pour objet un circuit électronique comportant :

- un substrat diélectrique,
- un composant électrique dont le rayonnement électromagnétique doit être mesuré, ce composant étant fixé sur le substrat,

caractérisé en ce qu'il comporte au moins un transducteur d'un dispositif de mesure conforme à l'invention, ce transducteur étant gravé sur le substrat pour mesurer le champ électromagnétique rayonné par le composant électrique.

Les modes de réalisation de ce circuit électronique peuvent comporter une ou plusieurs des caractéristiques suivantes :

- le composant électrique est une piste électrique gravée sur une face du substrat, et le transducteur du dispositif de mesure est gravé à côté de cette piste sur la même face du substrat ;
- le composant électrique est une piste électrique gravée sur une face du substrat, et le transducteur du dispositif de mesure est gravé sur une face opposée du substrat ;
- le circuit électronique est un commutateur de puissance comportant au moins une première et une seconde puces de commutation raccordées en parallèle par l'intermédiaire de la piste dont le rayonnement électromagnétique doit être mesuré ;
- il comporte un premier transducteur gravé sur le substrat à un emplacement choisi pour être plus exposé au champ électromagnétique créé par le courant commuté par la première puce qu'à celui créé par le courant commuté par la seconde puce.

L'invention a également pour objet un système de commutation comportant :

- un commutateur de puissance ayant au moins une première et une seconde puces de commutation, et un substrat diélectrique sur lequel est gravé une piste électrique raccordant en parallèle les première et seconde puces de commutation, et
- une unité de commande pour commander la commutation du commutateur de puissance,

caractérisé

- en ce que le système comporte un dispositif de mesure conforme à l'invention équipé d'un transducteur gravé sur le substrat du commutateur de puissance à un emplacement plus exposé au champ magnétique créé par le courant commuté par la première puce qu'à celui créé par le courant commuté par la seconde puce, et

- en ce que l'unité de commande est adaptée pour commander la commutation d'au moins l'une des puces fonction des mesures réalisées par le dispositif de mesure.

L'invention sera mieux comprise à la lecture de la description qui va suivre donnée uniquement à titre d'exemple et faite en se référant aux dessins sur lesquels :

- la figure 1 est un schéma électrique d'un système de commutation comportant plusieurs interrupteurs ;
- la figure 2 est un schéma électrique partiel d'un des interrupteurs du système de la figure 1 ;
- la figure 3 est une vue éclatée d'un commutateur utilisé pour réaliser l'un des interrupteurs du schéma électrique de la figure 2 ;
- la figure 4 est une vue de dessus du commutateur de la figure 3.

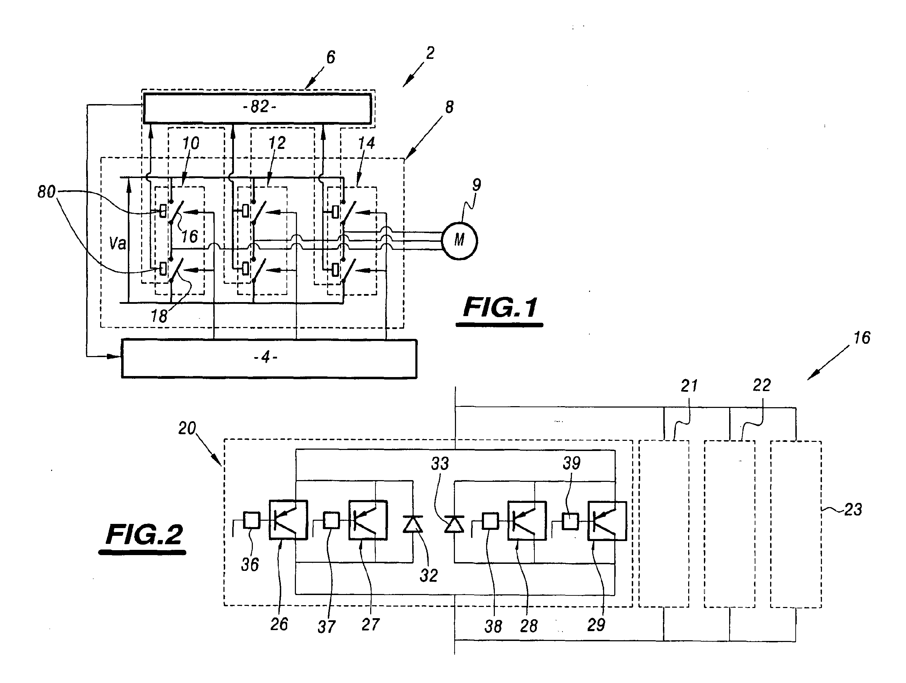

La figure 1 représente un système de commutation désigné par la référence générale 2. Ce système 2 comporte des interrupteurs de puissance associés à une unité de commande 4 de ces interrupteurs. Le système 2 comporte également un dispositif 6 de mesure du champ électromagnétique créé par les courants commutés par les interrupteurs.

Ici, le système 2 sera décrit dans le cas particulier où les interrupteurs sont agencés de manière à former un onduleur triphasé 8 propre à alimenter une machine électrique tournante 9 telle qu'un moteur de traction d'un train.

Le schéma électrique de l'onduleur 8 est classique. Il se compose de trois phases électriques identiques 10, 12 et 14 formées chacune de deux interrupteurs de puissance identiques 16 et 18. Chaque interrupteur de puissance est ici destiné à commuter des courants de plusieurs milliers d'ampères et apte à résister à des différences de potentiel de plusieurs milliers de volts.

A cet effet, chaque interrupteur est formé de plusieurs commutateurs électriques raccordés en parallèle.

La figure 2 représente un exemple d'interrupteur formé de quatre commutateurs identiques 20 à 23. Seul le commutateur 20 est représenté en détail.

A titre d'exemple, chaque commutateur se compose de quatre puces de commutation 26 à 29, raccordées en parallèle et de deux diodes 32, 33, raccordées en position antiparallèle aux bornes de ces puces. Chaque puce fonctionne comme un transistor et présente une électrode de grille, une électrode de collecteur et une électrode d'émetteur.

Chaque puce est, par exemple, capable de supporter une tension de 3 000 volts et un courant nominal maximal de 150 ampères. Pour cela, chaque puce est elle-même composée d'une matrice de transistors IGBT (Insulated Gate Bipolar Transistor) raccordés en parallèle et/ou en série. La grille de chacun de ces transistors IGBT est raccordée à l'électrode de grille de la puce de manière à ce que tous ces transistors IGBT soient commandés comme un seul et même transistor aux performances accrues. Le fait de raccorder en parallèle les transistors IGBT permet de réaliser une puce capable de commuter un courant beaucoup plus important que celui supporté par chacun des transistors qui la constituent.

L'électrode de grille de chacune des puces 26 à 29 est raccordée par l'intermédiaire d'une résistance respective 36 à 39 à une broche de grille.

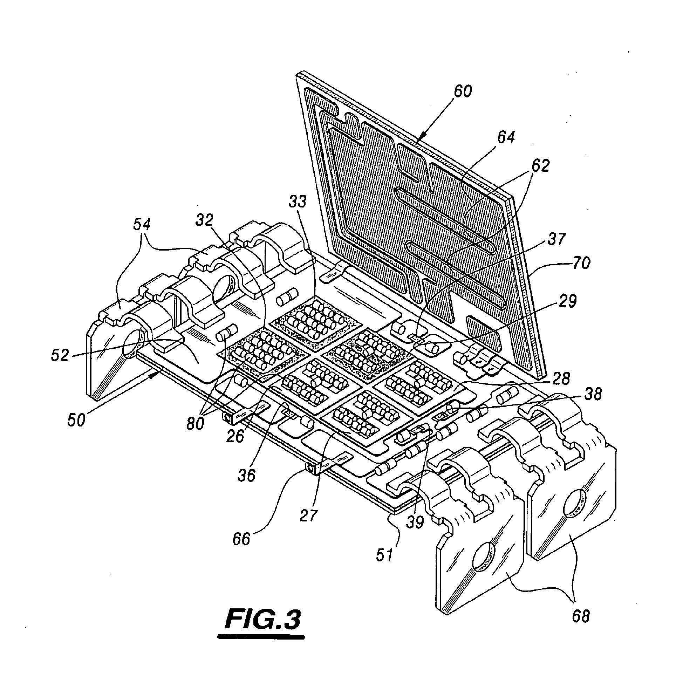

La figure 3 représente dans une vue en perspective la structure éclatée du commutateur 20. Le commutateur comporte un substrat 50, formé dans un matériau électriquement isolant, tel qu'un matériau diélectrique. Le substrat 50 est sensiblement rectangulaire et disposé à l'horizontale. Ce substrat présente une face extérieure tournée vers le bas et une face intérieure opposée tournée vers le haut.

La face extérieure est uniformément recouverte d'une fine couche 51 de métal pour former un blindage électromagnétique.

Sur la face intérieure du substrat 50, sont gravées des pistes électriques 52 raccordant les électrodes de collecteurs des puces 26 à 29 à des broches de collecteur 54. Ces broches de collecteur 54 sont soudées aux pistes 52 et font saillie vers l'extérieur sur le petit côté arrière du substrat 50.

Chaque puce comporte deux faces planes opposées. Ici, sur la figure 3, la face inférieure de chaque puce porte les électrodes de collecteur, tandis que la face supérieure porte les électrodes de grille et d'émetteur.

L'électrode de collecteur de chacune des puces 26 à 29 et la cathode des diodes 32 et 33 sont raccordés par brasage aux pistes 52. Le brasage permet, en plus du raccordement électrique d'assurer le raccordement thermique de l'électrode de collecteur au substrat 50.

Le commutateur 20 comporte également un substrat supérieur rectangulaire 60, formé dans un matériau électriquement isolant, tel qu'un matériau diélectrique. Ce substrat 60 présente deux faces planes et opposées dont une face intérieure tournée vers le substrat 50. Sur la face intérieure de ce substrat 60, sont également gravées des pistes électriques 62, 64. La piste 62 est destinée à raccorder les électrodes de grilles des puces 26 à 29 à une broche de grille 66 par l'intermédiaire des résistances 36 à 39. La piste 64 est destinée à raccorder les électrodes d'émetteurs des puces 26 à 29 à des broches d'émetteur 68. La piste 64 présente une grande surface pour favoriser les échanges thermiques avec l'extérieur et permettre, par exemple, un refroidissement efficace des puces.

Ici, les broches de grilles et d'émetteurs 66, 68 sont fixées sur le substrat 50.

Le substrat 60 comporte également une face extérieure, opposée à la face intérieure, sur laquelle est déposée une fine couche de métal 70 formant un blindage électromagnétique.

Le dispositif 6 de mesure du champ électromagnétique créé par les courants commutés par les interrupteurs 16 et 18 de l'onduleur 8 comporte un ensemble 80 (figure 1) de transducteurs associé à chacun des interrupteurs 16 et 18. Chacun des transducteurs de cet ensemble 80 est propre à convertir un champ électromagnétique en un courant ou un tension.

Le dispositif comporte également un appareil 82 de mesure du courant ou de la tension généré par chacun des transducteurs de l'ensemble 80.

L'unité de commande 4 est raccordée au dispositif 6 de manière à commander la commutation des interrupteurs 16 et 18 en fonction des mesures réalisées par ce dispositif 6. En particulier, l'unité 4 est adaptée pour commander la vitesse de commutation de chacun des commutateurs formant les interrupteurs 16 et 18 en fonction de la vitesse de commutation de chaque puce déduite des mesures réalisées par le dispositif 6.

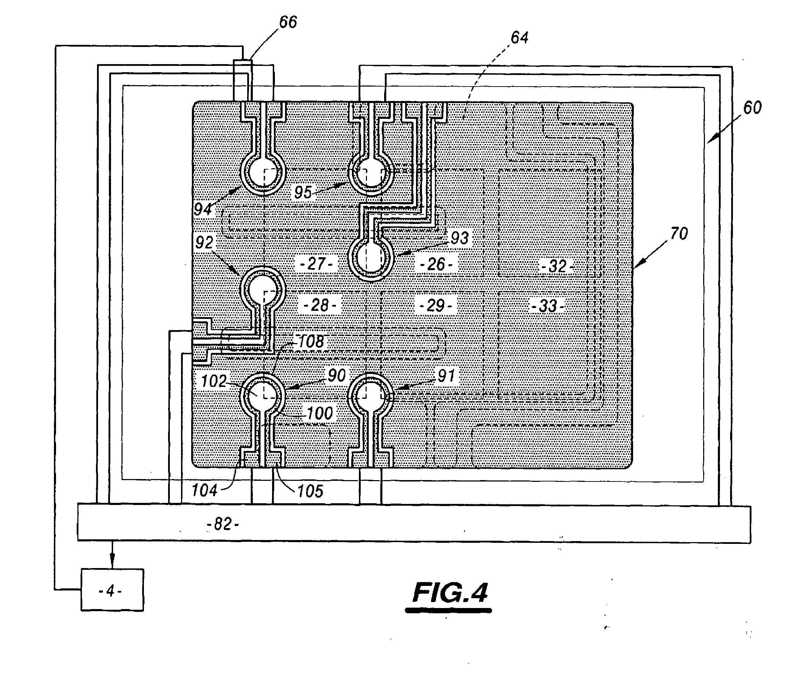

La figure 4 est une vue de dessus de la surface extérieure du substrat 60. Sur cette figure, la position des pistes 60 et 62 ainsi que la position des diodes 32 et 33 et des puces 26 à 29 sont représentées par des lignes en pointillés.

Dans le mode de réalisation décrit ici, les transducteurs de l'ensemble 80 sont gravés dans la fine couche de métal 70. Ici, six transducteurs 90 à 95 identiques sont représentés. Chacun de ces transducteurs est une bobine propre à convertir une variation du champ magnétique en un courant.

Seul le transducteur 90 sera décrit ici en détail.

Le transducteur 90 comporte une piste électrique 100 formant une boucle autour d'une surface 102 dépourvue de partie conductrice. Les extrémités de cette boucle 100 s'évasent pour former deux plots 104 et 105 de raccordement de la boucle 100 à l'appareil 82. Ces plots 104 et 105 sont formés sur la périphérie de la fine couche de métal 70 de manière à pouvoir être facilement raccordés à l'appareil 82. Ici, chaque transducteur est raccordé à l'appareil 82 par des liaisons filaires par exemple soudées à l'une de leurs extrémités aux plots de raccordement.

Ici, la surface 102 forme un cercle dont le rayon est de cinq millimètres. La boucle 100 est isolée électriquement de la fine couche métallique 70 par une bande 108 d'un millimètre de largeur dépourvue de partie conductrice. La largeur de la piste 100 est approximativement d'un millimètre.

La position et les dimensions de chaque transducteur 90 à 95 sont choisies de manière à mesurer le champ électromagnétique à un emplacement particulier du commutateur 20. Ici, chaque transducteur 90 à 95 est placé de manière à mesurer le champ magnétique créé par le courant commuté par une puce respective. Ceci sera décrit plus en détail ci-dessous.

Le fonctionnement du système 2 va maintenant être décrit.

L'unité 4 commande la commutation des interrupteurs 16 et 18 de l'onduleur 8. En réponse à cette commande, chacune des puces de chaque interrupteur commute d'un état bloqué vers un état passant ou vis-versa. Une telle commutation entraîne une variation du courant dans la piste 64. Cette variation de courant provoque une variation du champ magnétique rayonné par la piste 64. Cette variation de champ magnétique rayonné se traduit par une variation du flux magnétique traversant la surface 102 de chaque transducteur. La variation du flux magnétique traversant la surface 102 crée un courant électrique dans la piste électrique 100 raccordée à l'appareil 82. L'appareil 82 mesure l'intensité de ce courant électrique. A partir de l'intensité mesurée, l'appareil 82 en déduit des informations sur l'intensité du courant commuté par les puces. Par exemple, l'appareil 82 détermine le temps de commutation et la vitesse de variation $\dfrac{di}{dt}$ de l'intensité du courant commuté et transmet ces informations à l'unité de commande 4. En fonction de ces informations, l'unité 4 commande les puces, par exemple, pour accélérer ou au contraire réduire la vitesse de commutation de celles-ci.

Plus précisément, à cause, par exemple, de tolérances de fabrication, les puces 26 à 29 ne présentent pas rigoureusement les même caractéristiques techniques et fonctionnent de façon légèrement différentes. Par exemple, ces puces peuvent avoir des temps de commutation légèrement différents. A cause de ces différences et de la surface importante de la piste 64, la densité du courant commuté n'est pas uniforme sur toute la surface de la piste 64. Cette non uniformité de la densité de courant liée à des différences de caractéristiques ou de fonctionnement est ici mise à profit pour obtenir des informations sur le fonctionnement de chacune de ces puces. Ceci est rendu possible à cause du fait que chaque transducteur est essentiellement sensible au champ magnétique créé par la densité du courant commuté dans la surface de la piste 64 qui est en vis-à-vis de la surface 102. Dés lors, en plaçant un transducteur en vis-à-vis d'une surface de la piste 64 dont la densité de courant est représentative du courant commuté par une seule puce, ce transducteur mesure des informations sur le courant commuté par cette seule puce et non pas par l'ensemble des puces raccordées à cette piste 64. L'appareil 82, en traitant les signaux mesurés par ce transducteur, en déduit des informations sur le fonctionnement de cette puce particulière telle que, par exemple, le temps de commutation à l'ouverture et/ou à la fermeture. Ici, l'appareil 82 délivre ce temps de commutation à l'unité de commande 4 qui utilise alors cette information pour commander les puces.

Le temps de commutation est aussi une information qui permet de détecter à l'avance la défaillance d'une puce. Ici, l'unité 4 est également apte à commander le passage du commutateur 20 dans un état de sécurité avant même que la puce qui présente une défaillance n'explose.

Toujours dans ce souci de relever des informations sur le fonctionnement d'une puce particulière parmi l'ensemble des puces formant le commutateur 20, la dimension de la surface 102 est choisie pour ne recouvrir qu'une partie de la largeur totale de la piste 64. Ici, la dimension de la surface 102 est également choisie pour présenter un bon compromis entre d'une part la résolution spatiale qui croît lorsque la surface 102 décroît et la sensibilité du transducteur qui décroît lorsque la surface 102 décroît.

Le dispositif 6 présente de nombreux avantages. En particulier, les erreurs de mesure dues à un positionnement imprécis du transducteur vis-à-vis de la piste électrique dont on souhaite mesurer le rayonnement électromagnétique sont évitées puisque le transducteur est gravé dans le même substrat que celui utilisé pour graver la piste électrique. Ensuite le fait de graver les transducteurs dans la fine couche métallique formant blindage électromagnétique permet de mesurer le champ électromagnétique à l'intérieur du commutateur alors même que celui-ci est pourvu d'un blindage électromagnétique.

Les transducteurs 90 à 95 ont été décrits dans le cas particulier où ils sont gravés sur une face du substrat opposée à celle sur laquelle est formée la piste électrique dont on souhaite mesurer le rayonnement électromagnétique. Dans une telle configuration, les transducteurs n'occupent pas de place sur la face utile du substrat, c'est-à-dire la face comportant les pistes électriques du commutateur. Toutefois, en variante, les transducteurs sont gravés à côté de la piste électrique dont on souhaite mesurer le rayonnement électromagnétique et sur la même face du substrat que celle portant cette piste électrique. Cette dernière configuration présente l'avantage d'accroître la sensibilité du transducteur puisque celui-ci est mieux exposé au flux magnétique généré par la piste électrique.

Les transducteurs ont été décrits dans le cas particulier où ils sont formés d'une bobine comportant une seule spire formée par la piste 100. En variante, pour augmenter la sensibilité, la bobine à une seule spire est remplacée par une bobine multi-spires gravée sur le substrat du commutateur.

Les transducteurs ont été décrits ici dans le cas particulier où ils comportent une piste 100 délimitant une surface circulaire 102 dont le rayon est égal à cinq millimètres. Pour accroître la résolution spatiale, il est possible de diminuer ce rayon. Il est également possible d'augmenter le rayon de cette surface 102 pour augmenter la sensibilité du transducteur.

Le dispositif 6 est apte à mesurer le rayonnement électromagnétique d'autres composants électriques fixés sur un substrat d'un circuit électronique et pas seulement d'une piste électrique. Par exemple, le dispositif 6 est, en variante, adapté pour mesurer le champ électromagnétique d'un composant électrique soudé sur le substrat, tel qu'un relais électrique, un transistor ou un microcontrôleur.

Enfin, le dispositif 6 a été décrit dans le cas particulier où il est appliqué à la mesure de champs magnétiques générés par une piste d'un commutateur de puissance. Toutefois, l'enseignement de ce brevet n'est pas limité à de tels commutateurs mais s'applique à tous types de circuits électroniques comportant un substrat sur lequel peut être gravé un transducteur et de préférence une bobine électrique formant transducteur. Par exemple, le dispositif 6 est appliqué à des cartes électroniques comportant des composants électroniques analogiques ou numériques soudés sur un substrat ou encore à des circuits intégrés. Dans le cas des circuits intégrés, les dimensions d'un transducteur sont, par exemple, de l'ordre de quelques micromètres.

## Revendications

**1.** Dispositif de mesure d'un champ électromagnétique rayonné par un composant électrique d'un circuit électronique, le composant électrique étant fixé sur un substrat diélectrique du circuit électronique, ce dispositif comportant :

- un appareil (82) de mesure d'une énergie électrique indépendant du circuit électronique,
- au moins un transducteur (90 à 95) raccordé à l'appareil de mesure, ce transducteur étant apte à convertir le champ électromagnétique rayonné par le composant électrique en une énergie électrique mesurée par l'appareil de mesure,

**caractérisé en ce que** le ou chaque transducteur est gravé sur le substrat du circuit électronique.

**2.** Dispositif selon la revendication 1, **caractérisé en ce que** le ou chaque transducteur (90 à 95) comporte une bobine, et **en ce que** l'appareil de mesure est apte à mesurer l'intensité du courant dans cette bobine.

**3.** Dispositif selon la revendication 2, **caractérisé en ce que** la bobine est formée d'une piste électrique (100) en forme de boucle gravée sur le substrat et dont les deux extrémités forment des plots de raccordement de la bobine à l'appareil de mesure.

**4.** Dispositif selon la revendication 2 ou 3, **caractérisé en ce que** la bobine ne comporte qu'une seule spire.

**5.** Dispositif selon l'une quelconque des revendications précédentes, pour un circuit électronique dans lequel le composant électrique dont on doit mesurer le champ électromagnétique rayonné est une piste électrique raccordant en parallèle au moins une première et une seconde puces de commutation de courant, **caractérisé en ce que** le ou l'un des transducteurs (90 à 95) est gravé sur le substrat à un emplacement choisi pour être plus exposé au champ électromagnétique créé par le courant commuté par la première puce que celui créé par le courant commuté par la seconde puce.

**6.** Circuit électronique comportant :

- un substrat diélectrique (60),
- un composant électrique (26 à 29) dont le rayonnement électromagnétique doit être mesuré, ce composant étant fixé sur le substrat, **caractérisé en ce qu'**il comporte au moins un transducteur (90 à 95) d'un dispositif de mesure conforme à l'une quelconque des revendications précédentes, ce transducteur étant gravé sur le substrat pour mesurer le champ électromagnétique rayonné par le composant électrique.

**7.** Circuit selon la revendication 6, **caractérisé en ce que** le composant électrique est une piste électrique (64) gravée sur une face du substrat, et **en ce que** le transducteur du dispositif de mesure est gravé à côté de cette piste sur la même face du substrat.

**8.** Circuit selon la revendication 6, **caractérisé en ce que** le composant électrique est une piste électrique (64) gravée sur une face du substrat, et **en ce que** le transducteur du dispositif de mesure est gravé sur une face opposée du substrat.

**9.** Circuit selon la revendication 7 ou 8, **caractérisé en ce que** le circuit électronique est un commutateur de puissance comportant au moins une première et une seconde puces (26 à 29) de commutation raccordées en parallèle par l'intermédiaire de la piste dont le rayonnement électromagnétique doit être mesuré.

**10.** Circuit selon la revendication 9, **caractérisé en ce qu'**il comporte un premier transducteur (90 à 95) gravé sur le substrat à un emplacement choisi pour être plus exposé au champ électromagnétique créé par le courant commuté par la première puce qu'à celui créé par le courant commuté par la seconde puce.

**11.** Système de commutation de puissance comportant :

- un commutateur (20) de puissance ayant au moins une première et une seconde puces (28, 29) de commutation, et un substrat diélectrique (60) sur lequel est gravée une piste électrique (64) raccordant en parallèle les première et seconde puces de commutation, et
- une unité (4) de commande pour commander la commutation du commutateur de puissance, caractérisé
- en ce que le système comporte un dispositif (6) de mesure conforme à la revendication 5 équipé d'un transducteur (90) gravé sur le substrat du commutateur de puissance à un emplacement plus exposé au champ magnétique créé par le courant commuté par la première puce (28) qu'à celui créé par le courant commuté par la seconde puce (29), et
- en ce que l'unité de commande est adaptée pour commander la commutation d'au moins l'une des puces fonction des mesures réalisées par le dispositif de mesure.

**Patentansprüche**

**1.** Vorrichtung zum Messen eines elektromagnetischen Feldes, das von einer elektrischen Komponente einer elektronischen Schaltung ausgestrahlt wird, wobei die elektrische Komponente auf einem dielektrischen Substrat der elektronischen Schaltung befestigt ist, wobei die Vorrichtung aufweist:

- ein Gerät (82) zum Messen einer elektrischen Energie unabhängig von der elektronischen Schaltung,
mindestens einen Wandler (90 bis 95), der an das Gerät zum Messen angeschlossen ist, wobei der Wandler eingerichtet ist, das von der elektrischen Komponente abgestrahlte elektromagnetische Feld in eine von dem Gerät zum Messen gemessene elektrische Energie umzuwandeln,
dadurch charakterisiert, dass der oder jeder Wandler auf das Substrat der elektronischen Schaltung geätzt ist.

**2.** Vorrichtung gemäß Anspruch 1, dadurch charakterisiert, dass der oder jeder Wandler (90 bis 95) eine Spule aufweist und dadurch, dass das Gerät zum Messen eingerichtet ist, die Stärke des Stroms in dieser Spule zu messen.

**3.** Vorrichtung gemäß Anspruch 2, dadurch charakterisiert, dass die Spule durch eine elektrische Spur (100) in der Form einer Spule ausgebildet ist, die auf das Substrat geätzt ist und deren zwei Enden Kontakte zum Anschließen der Spule an das Gerät zum Messen bilden.

**4.** Vorrichtung gemäß Anspruch 2 oder 3, dadurch charakterisiert, dass die Spule nur eine einzige Windung aufweist.

**5.** Vorrichtung gemäß einem der vorhergehenden Ansprüche für eine elektronische Schaltung, in der die elektrische Komponente, deren ausgestrahltes elektromagnetisches Feld man messen muss, eine elektrische Spur ist, die mindestens einen ersten Schaltchip und einen zweiten Schaltchip parallel schaltet, dadurch charakterisiert, dass der oder der eine der Wandler (90 bis 95) an einem Platz auf das Substrat geätzt ist, der derart gewählt ist, dass er dem elektromagnetischen Feld, das durch den Strom, der von dem ersten Chip geschaltet wird, erzeugt wird, stärker ausgesetzt ist als dem, das durch den Strom, der von dem zweiten Chip geschaltet wird, erzeugt wird.

**6.** Elektronische Schaltung aufweisend:

- ein dielektrisches Substrat (60),
- eine elektrische Komponente (26 bis 29), deren elektromagnetische Strahlung man messen muss, wobei die Komponente auf dem Substrat befestigt ist,
dadurch charakterisiert, dass es mindestens einen Wandler (90 bis 95) einer Messvorrichtung gemäß einem der vorhergehenden Ansprüche aufweist, wobei der Wandler zum Messen des von der elektrischen Komponente ausgestrahlten elektrischen Feldes auf das Substrat geätzt ist.

**7.** Schaltung gemäß Anspruch 6, dadurch charakterisiert, dass die elektrische Komponente eines elektrische Spur (64) ist, die auf eine Seite des Substrats geätzt ist und dadurch, dass der Wandler der Messvorrichtung neben dieser Spur auf dieselbe Seite des Substrats geätzt ist.

**8.** Schaltung gemäß Anspruch 6, dadurch charakterisiert, dass die elektrische Komponente eine elektrische Spur (64) ist, die auf eine Seite des Substrats geätzt ist und dadurch, dass der Wandler der Messvorrichtung auf eine entgegengesetzte Oberfläche des Substrats geätzt ist.

**9.** Schaltung gemäß Anspruch 7 oder 8, dadurch charakterisiert, dass die elektronische Schaltung ein Leistungsschalter ist, der mindestens einen ersten Schaltchip und einen zweiten Schaltchip (26 bis 29) aufweist, die mittels der Spur, deren elektromagnetische Strahlung gemessen werden muss, parallel geschaltet sind.

**10.** Schaltung gemäß Anspruch 9, dadurch charakterisiert, dass sie einen ersten Wandler (90 bis 95) aufweist, der an einem Platz auf das Substrat geätzt ist, der derart gewählt ist, dass er dem elektromagnetischen Feld, das durch den Strom, der von dem ersten Chip geschaltet wird, erzeugt wird, stärker ausgesetzt ist als dem, das durch den Strom, der von dem zweiten Chip geschaltet wird, erzeugt wird.

**11.** Leistungsschaltsystem aufweisend:

- einen Leistungsschalter (20), der mindestens einen ersten Schaltchip und einen zweiten Schaltchip (28, 29) und ein dielektrisches Substrat (60) aufweist, auf den eine elektrische Spur (64) geätzt ist, die den ersten Schaltchip und den zweiten Schaltchip parallel schaltet und
- eine Steuereinheit (4) zum Steuern des Schaltens des Leistungsschalters,
charakterisiert
- dadurch, dass das System eine Messvorrichtung (6) gemäß Anspruch 5 aufweist, ausgestattet mit einem Wandler (90), der an einem Platz auf das Substrat des Leistungsschalters geätzt ist, der dem elektromagnetischen Feld, das durch den Strom, der von dem ersten Chip (28) geschaltet wird, erzeugt wird, stärker ausgesetzt ist als dem, das durch den Strom, der von dem zweiten Chip (29) geschaltet wird, erzeugt wird und
- dadurch, dass die Steuereinheit eingerichtet ist, das Schalten mindestens eines der Chips in Abhängigkeit der von der Messeinrichtung durchgeführten Messungen zu steuern.

**Claims**

**1.** A device for measuring an electromagnetic field radiated by an electrical component of an electronic circuit, the electrical component being fixed to a dielectric substrate of the electronic circuit, this device comprising:

- an apparatus (82) for measuring an electrical energy independent of the electronic circuit, and
- at least one transducer (90 to 95) connected to the measuring apparatus, this transducer being adapted to convert the electromagnetic field radiated by the electrical component into an electrical energy measured by the measuring apparatus,
**characterized in that** the or each transducer is etched on the substrate of the electronic circuit.

**2.** A device according to claim 1, **characterized in that** the or each transducer (90 to 95) includes a coil, and **in that** the measuring apparatus is adapted to measure the current intensity in this coil.

**3.** A device according to claim 2, **characterized in that** the coil is formed of a looped electrical track (100) etched on the substrate and whose two ends form lands for connecting the coil to the measuring apparatus.

4. A device according to claim 2 or 3, **characterized in that** the coil has only one turn.

5. A device according to any one of the preceding claims, for an electronic circuit wherein the electrical component whose radiated electronic field is to be measured is an electrical track connecting in parallel first and second current switching chips, **characterized in that** the or one of the transducers (90 to 95) is etched on the substrate at a location chosen to be more exposed to the electromagnetic field generated by the current switched by the first chip than that generated by the current switched by the second chip.

6. An electronic circuit comprising:

   - a dielectric substrate (60), and
   - an electrical component (26 to 29) whose electromagnetic radiation is to be measured, this component being fixed on the substrate,
   **characterized in that** it includes at least one transducer (90 to 95) of a measuring device according to any one of the preceding claims, this transducer being etched on the substrate to measure the electromagnetic field radiated by the electrical component.

7. A circuit according to claim 6, **characterized in that** the electrical component is an electrical track (64) etched on one face of the substrate, and **in that** the transducer of the measuring device is etched alongside this track on the same face of the substrate.

8. A circuit according to claim 6, **characterized in that** the electrical component is an electrical track (64) etched on one face of the substrate, and **in that** the transducer of the measuring device is etched on an opposite face of the substrate.

9. A circuit according to claim 7 or 8, **characterized in that** the electronic circuit is a power switch including at least a first and a second switching chips (26 to 29) connected in parallel by the track whose electromagnetic radiation is to be measured.

10. A circuit according to claim 9, **characterized in that** it includes a first transducer (90 to 95) etched on the substrate at a location chosen to be more exposed to the electromagnetic field generated by the current switched by the first chip than to that generated by the current switched by the second chip.

11. A power switching system comprising:

   - a power switch (20) having at least a first and a second switching chips (28, 29), and a dielectric substrate (60) on which an electrical track (64) connecting the first and second switching chips in parallel is etched, and
   - a control unit (4) for controlling the switching of the power switch,
   **characterized**
   - in that the system includes a measuring device (6) according to claim 5 equipped with a transducer (90) etched on the substrate of the power switch at a location more exposed to the magnetic field generated by the current switched by the first chip (28) than to that generated by the current switched by the second chip (29), and
   - in that the control unit is adapted to control the switching of at least one of the chips as a function of the measurements carried out by the measuring device.

**_FIG.1_**

**_FIG.2_**

**FIG.3**

EP 1 596 209 B1

FIG.4

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 4904925 A